# EUROPEAN PATENT APPLICATION

(11) **EP 4 687 192 A1**
(43) Date of publication of application: **04.02.2026**
(21) Application number: 25169780.1
(22) Date of filing: 10.04.2025
(51) Int. Cl.: H01M 10/42, H01M 10/48

(54) **BATTERY MANAGEMENT SYSTEM CAPABLE OF SUPPORTING PLURALITY OF SECONDARY BATTERY MODULES**

(30) Priority: 31.07.2024 KR 20240102167
(71) Applicant: SAMSUNG SDI CO., LTD., Yongin-si, Gyeonggi-do 17084 (KR)
(72) Inventor: MOON, Daehee, Yongin-si, Gyeonggi-do 17084 (KR); SEO, Youngdong, Yongin-si, Gyeonggi-do 17084 (KR); YOO, Jae Shik, Yongin-si, Gyeonggi-do 17084 (KR)
(74) Representative: Marks & Clerk LLP

(57) **Abstract**

The present disclosure relates to a battery management system (BMS) for managing a secondary battery, and to a method capable of supporting various types of applications and cell types with one BMS. To this end, the present disclosure provides a BMS that may include general-purpose input/output (GPIO) ports connected to a secondary battery module, a plurality of module support programs configured to support a plurality of secondary battery module types and various cell types, a configuration information designation port configured to designate configuration information of the module support program and included in the GPIO ports, and a module support unit configured to detect a state of the configuration information designation port to recognize a type of the secondary battery module and a cell type and retrieve the module support program corresponding to the type and the cell type to manage the secondary battery module.

## Description

### FIELD

The present disclosure relates to a battery management system for managing a secondary battery.

### BACKGROUND

Unlike primary batteries that cannot be recharged, secondary batteries are batteries that can be charged and discharged. Low-capacity secondary batteries are used in small portable electronic devices such as smartphones, feature phones, laptop computers, digital cameras, and camcorders, and high-capacity secondary batteries are widely used as driving power sources and power storage batteries for motors in hybrid vehicles, electric vehicles, and the like. Such a secondary battery can include an electrode assembly including a positive electrode and a negative electrode, a case for accommodating the same, and an electrode terminal connected to the electrode assembly.

A secondary battery module or a secondary battery pack may include a battery management system (BMS) for managing a battery. BMSs measure and grasp a voltage (V), a current (I), and a temperature (T) of batteries mounted on electric vehicles or energy storage systems (ESSs) in advance through sensors and perform control such that the batteries exhibit optimal performance.

The above information disclosed in this Background section is for enhancement of understanding of the background of the present disclosure, and therefore, it may contain information that does not constitute related (or prior) art.

### SUMMARY

According to some aspects, the present disclosure is directed to providing a method in which various types of applications and cell types may be supported with one battery management system (BMS).

According to some aspects of the present disclosure, there is provided a BMS including general-purpose input/output (GPIO) ports connected to a secondary battery module, a plurality of module support programs configured to support a plurality of secondary battery module types and various cell types, a configuration information designation port configured to designate configuration information of a module support program of the plurality of module support programs and included in the GPIO ports, and a module support unit configured to detect a state of the configuration information designation port to recognize and/or identify a type of the secondary battery module and a cell type and configured to retrieve the module support program corresponding to the type and the cell type to manage the secondary battery module.

In some embodiments, the BMS may further comprise a module information storage unit configured to store information indicating the type of the secondary battery module; a cell information storage unit configured to store information indicating the cell type of a cell included in the secondary battery module; a configuration information storage unit configured to store configuration information for each secondary battery module type stored in the module information storage unit and configuration information for each cell type stored in the cell information storage unit; and a designation state detection unit configured to read the state of the configuration information designation port and detect a state designated according to the secondary battery module.

In some embodiments, the module support unit may be configured to retrieve configuration information for each type of the secondary battery module and configuration information for each cell type, which correspond to the detected state that is designated, and configured to retrieve and execute the module support program for the secondary battery module.

In some embodiments, the configuration information of the configuration information storage unit may be information that is used when constituting, retrieving, and executing the module support program.

In some embodiments, the configuration information designation port is at least one port among the GPIO ports.

In some embodiments, the configuration information designation port includes a pair of pull-up and pull-down resistors connected to each port among the GPIO ports.

In some embodiments, the configuration information designation port includes: a pair of pull-up and pull-down resistors connected to each port among the GPIO ports; a first switch configured to switch on or off the pull-up resistor; and a second switch configured to switch on or off the pull-down resistor.

In some embodiments, the BMS may further comprise a wake-up processing unit, wherein the module support unit is further configured to detect a designation state at a time point, at which the wake-up processing unit is configured to wake up the battery management system and restart an operation of the battery management system.

In some embodiments, the designation state detection unit may be configured to: detect a configuration information designation state from the configuration information designation port to determine a module type and cell type designated in the secondary battery module from the detected state designated according to the secondary battery module, perform a communication test with the secondary battery module, and verify the cell type of the cell included in the secondary battery module.

According to other aspects of the present disclosure, there is provided a secondary battery pack including a secondary battery module, and a BMS including general-purpose input/output (GPIO) ports, a module support program configured to support the secondary battery module, a configuration information designation port configured to designate configuration information of the module support program and included in the GPIO ports, and a module support unit configured to detect a state of the configuration information designation port to recognize a type of the secondary battery module and a cell type and retrieve the module support program corresponding to the type and the cell type to manage the secondary battery module.

In some embodiments, the BMS may further include: a module information storage unit configured to store information indicating the type of the secondary battery module; a cell information storage unit configured to store information indicating a type of a cell included in the secondary battery module; a configuration information storage unit configured to store configuration information for each secondary battery module type stored in the module information storage unit and configuration information for each cell type stored in the cell information storage unit; and a designation state detection unit configured to read the state of the configuration information designation port and to detect a state designated according to the secondary battery module.

In some embodiments, the configuration information designation port may be at least one port among the GPIO ports.

In some embodiments, the configuration information designation port may include a pair of pull-up and pull-down resistors connected to each port among the GPIO ports.

In some embodiments, the configuration information designation port may include: a pair of pull-up and pull-down resistors connected to each port among the GPIO ports; a first switch configured to switch on or off the pull-up resistor; and a second switch configured to switch on or off the pull-down resistor.

In some embodiments, the designation state detection unit may be configured to: detect a configuration information designation state from the configuration information designation port to determine a module type and cell type designated in the secondary battery module, perform a communication test with the secondary battery module, and verify a type of a cell included in the secondary battery module.

According to other aspects of the present disclosure, a method of operating a battery management system comprising general-purpose input/output (GPIO) ports connected to a secondary battery module and a configuration information designation port included in the GPIO ports configured to designate configuration information of a module support program of a plurality of module support programs configured to support a plurality of secondary battery module types and various cell types, may include: detecting, via a module support unit, a state of the configuration information designation port to identify a type of the secondary battery module and a cell type; and retrieving, via the module support unit, the module support program, wherein the module support program corresponds to the type and the cell type to manage the secondary battery module.

However, features and aspects of the present disclosure are not limited to the above, and other features and aspects not specifically mentioned herein, and aspects of the present disclosure that would address problems identified in the present disclosure, will be clearly understood by those skilled in the art from the description of the present disclosure below.

At least some of the above and other features of the invention are set out in the claims.

### BRIEF DESCRIPTION OF THE DRAWINGS

The following drawings accompanying the present specification illustrate embodiments of the present disclosure, and further describe aspects of the present disclosure together with the detailed description of the present disclosure. Thus, the present disclosure should not be construed as being limited to the drawings:
FIG. 1 schematically illustrates a pouch-type secondary battery, according to some embodiments;
FIG. 2 is a cross-sectional view of a cylindrical secondary battery, according to some embodiments;
FIG. 3A is a top perspective view illustrating an exterior of a prismatic secondary battery, according to some embodiments;
FIG. 3B is a cross-sectional view along line I-I' of FIG. 3A;
FIG. 4 is an example view of a secondary battery module in which secondary batteries are arranged, according to some embodiments;
FIG. 5 is an example view of a secondary battery pack constructed to apply the secondary battery module shown in FIG. 4 to an actual product;
FIG. 6 is a view showing a vehicle including the secondary battery pack shown in FIG. 5;
FIG. 7 is a block diagram of a battery management system (BMS) according to some embodiments of the present disclosure;
FIG. 8 illustrates embodiments in which one configuration information designation port among general-purpose input/output (GPIO) ports is used;
FIG. 9 illustrates other embodiments in which two configuration information designation ports among the GPIO ports are used;
FIG. 10 illustrates embodiments in which three configuration information designation ports among the GPIO ports are used;
FIG. 11A illustrates a method of setting a state of a configuration information designation port according to some embodiments;
FIG. 11B illustrates a method of setting a state of a configuration information designation port according to other embodiments;
FIG. 12 illustrates a configuration of a BMS according to other embodiments of the present disclosure; and
FIG. 13 illustrates a process in which a designation state detection unit of a BMS, according to some embodiments, detects a configuration information designation state and determines integrity by reading a configuration information designation port.

### DETAILED DESCRIPTION

Hereinafter, embodiments of the present disclosure will be described, in detail, with reference to the accompanying drawings. The terms or words used in the present specification and claims are not to be limitedly interpreted as general or dictionary meanings and should be interpreted as meanings and concepts that are consistent with the technical idea of the present disclosure on the basis of the principle that an inventor can be his/her own lexicographer to appropriately define concepts of terms.

The embodiments described in this specification and the configurations shown in the drawings are only some of one or more embodiments of the present disclosure and do not represent all of the aspects of the present disclosure. Accordingly, it should be understood that there may be various equivalents and modifications that can replace or modify one or more embodiments described herein at the time of filing this application.

It will be understood that if an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, if a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals may designate the same elements. As used herein, the term "and/or" includes any and all combinations of one or more of the associated listed items. Further, the use of "may" if describing embodiments of the present disclosure relates to "one or more embodiments of the present disclosure." Expressions, such as "at least one of" and "any one of," if preceding a list of elements, modify the entire list of elements and do not modify the individual elements of the list. When phrases such as "at least one of A, B and C," "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," if used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of patent rules.

References to two compared elements, features, etc. as being "the same" may mean that they are "substantially the same." Thus, the phrase "substantially the same" may include a case having a deviation that is considered low in the art, for example, a deviation of 5% or less. In addition, if a certain parameter is referred to as being uniform in a given region, it may mean that it is uniform in terms of an average.

Throughout the specification, unless otherwise stated, each element may be singular or plural. In some examples, when "one" element is described, that element is singular.

Arranging an arbitrary element "above (or below)" or "on (or under)" another element may mean that the arbitrary element may contact the upper (or lower) surface of the element, and another element may also be interposed between the element and the arbitrary element located on (or under) the element.

In addition, it will be understood that if a component is referred to as being "linked," "coupled," or "connected" to another component, the elements may be directly "coupled," "linked" or "connected" to each other, or another component may be "interposed" between the components.

Throughout the specification, if "A and/or B" is stated, it means A, B or A and B, unless otherwise stated. That is, "and/or" includes any or all combinations of a plurality of items enumerated. When "C to D" is stated, it means C or more and D or less, unless otherwise specified.

The terminology used herein is for the purpose of describing embodiments of the present disclosure and is not intended to limit the present disclosure.

BMSs have differentiated protection scopes and functions according to information about each secondary battery cell, usage applications, and cell characteristics. For example, in the case of a low emission vehicle (LEV), different BMSs should be developed and applied according to cell types and whether smart modules are supported.

According to some embodiments, various types of applications and cell types may be supported with one battery management system (BMS).

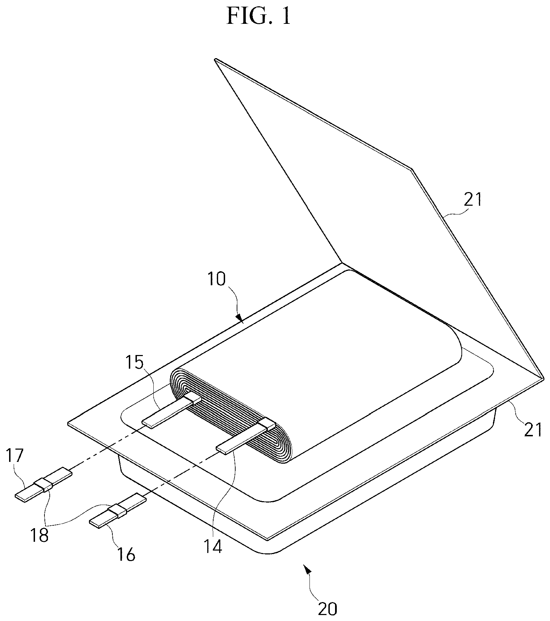

FIG. 1 schematically illustrates a pouch-type secondary battery.

The pouch-type secondary battery includes an electrode assembly 10 and a pouch 20 that accommodates the electrode assembly 10.

The electrode assembly 10 is illustrated in FIG. 1. A first electrode tab 14 and a second electrode tab 15 of the electrode assembly 10 may be electrically connected to respective external first and second terminal leads 16 and 17 by welding. Each of the first terminal lead 16 and the second terminal lead 17 may be attached with a tab film 18 for insulation from the pouch 20.

The pouch 20 may be sealed by having sealing parts 21 at the edges thereof come into contact with each other while accommodating the electrode assembly 10 therein, in which case the sealing may be achieved with the tab film 18 interposed between the sealing parts 21. The sealing parts 21 of the pouch 20 may each be made of a thermal fusion material that generally has weak adhesion to metal. Thus, it may be fused to the pouch 20 by interposing the thin tab film 18 between the sealing parts 21.

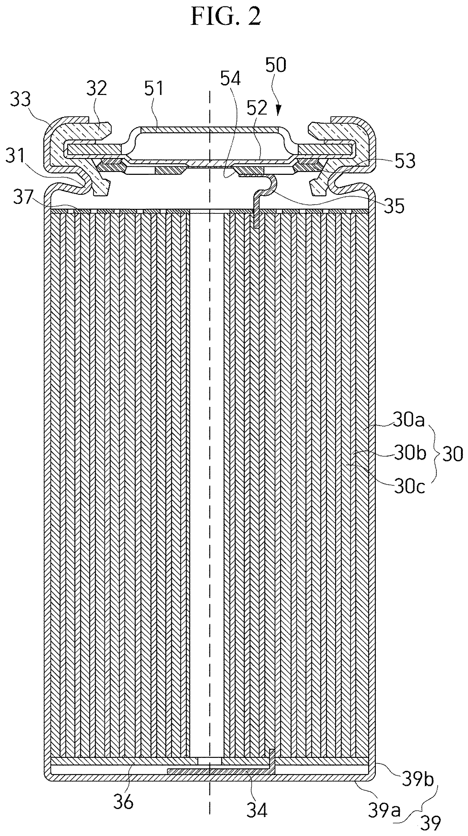

FIG. 2 illustrates a cylindrical secondary battery. As shown in FIG. 2 the secondary battery includes an electrode assembly 30, a case 39 accommodating the electrode assembly 30 and an electrolyte therein, a cap assembly 50 coupled to an opening of the case 39 to seal the case 39, and an insulating plate 37 positioned between the electrode assembly 30 and the cap assembly 50 inside the case.

The electrode assembly 30 may include a separator 30b and a first electrode 30c and a second electrode 30a positioned with the separator interposed therebetween and may be wound in a jelly-roll shape.

The first electrode 30c may include a first substrate and a first active material layer on the first substrate. A first lead tab 35 may extend outwardly from a first uncoated portion of the first substrate where the first active material layer is not located, and the first lead tab 35 may be electrically connected to the cap assembly 50.

The second electrode 30a may include a second substrate and a second active material layer on the second substrate. A second lead tab 34 may extend outwardly from a second uncoated portion of the second substrate where the second active material layer is not located, and the second lead tab 34 may be electrically connected to the case 39. The first lead tab 35 and the second lead tab 34 may extend in opposite directions.

The first electrode 30c may act as a positive electrode. In such an embodiment, the first substrate may be made of, for example, an aluminum foil, and the first active material layer may include, for example, a transition metal oxide. The second electrode 30a may act as a negative electrode. In such an embodiment, the second substrate may be made of, for example, a copper foil or a nickel foil, and the second active material layer may include graphite, for example.

The separator 30b prevents a short circuit between the first electrode and the second electrode while allowing movement of lithium ions therebetween. The separator 30b may be made of, for example, a polyethylene film, a polypropylene film, a polyethylene-polypropylene film, or the like.

The case 39 may accommodate the electrode assembly 30 and, together with the cap assembly 50, form the external appearance of the secondary battery. The case 39 may have a substantially cylindrical body portion 39b and a bottom portion 39a connected to one side (e.g., to one end) of the body portion 39b. A beading part 31 (e.g., a bead) deformed inwardly may be formed in the body portion 39b, and a crimping part 33 (e.g., a crimp) bent inwardly may be formed at an open end of the body portion 39b.

The beading part 31 can reduce or prevent movement of the electrode assembly 30 inside the case 39 and can facilitate seating of a gasket 32 and the cap assembly 50. The crimping part 33 may firmly fix the cap assembly 50 by pressing the edge of the case 39 against the gasket 32. The case 39 may be formed of iron plated with nickel, for example.

The cap assembly 50 may be fixed to the inside of the crimping part 33 by a gasket 32 to seal the case 39. The cap assembly 50 may include a cap up 51, a safety vent 52, a cap down 53, an insulating member, and a sub plate 54 but is not limited thereto and may be modified in various ways.

The cap up 51 may be positioned at the uppermost part of the cap assembly 50. The cap up 51 may include a terminal part that protrudes upwardly and is connected to an external circuit, and an outlet for discharging gas may be arranged around the terminal part.

The safety vent 52 may be located under the cap up 51. The safety vent 52 may include a protrusion part that protrudes convexly downwardly and is connected to the sub plate 54, and at least one notch may be formed in the safety vent around the protrusion part.

When gas is generated due to overcharging or abnormal operation of the secondary battery, the protrusion part is deformed upwardly by the pressure and separates from the sub plate 54 while the safety vent 52 is cut (e.g., bursts or tears) along the notch. The cut safety vent 52 may prevent the secondary battery from exploding by allowing for the gas to be discharged to the outside.

The cap down 53 may be below the safety vent 52. The cap down 53 may have a first opening for exposing the protrusion part of the safety vent 52 and a second opening for gas discharge. The insulating member may be positioned between the safety vent 52 and the cap down 53 to insulate the safety vent 52 and the cap down 53.

The sub plate 54 may be under the cap down 53. The sub plate 54 may be fixed to a lower surface of the cap down 53 to block the first opening of the cap down 53, and the protrusion part of the safety vent 53 may be fixed to the sub plate 54. The first lead tab 35, which is drawn out from the electrode assembly 30 may be fixed to the sub plate 54. Accordingly, the cap up 51, the safety vent 52, the cap down 53, and the sub plate 54 may be electrically connected to the first electrode 30c of the electrode assembly 30.

The insulating plate 37 may be positioned to be in contact with the electrode assembly 30 below the beading part 31. The insulating plate 37 may have a tab opening through which the first lead tab 35 is drawn out. The cap assembly 50, which is electrically connected to the first electrode by the first lead tab, may face the electrode assembly with an insulating plate 37 interposed therebetween and may maintain a state of being insulated (e.g., electrically insulated) from the electrode assembly 30 by the insulating plate 37. Meanwhile, another insulating plate 36 may be included for insulation between the electrode assembly 30 and the bottom portion 39a of the case 39.

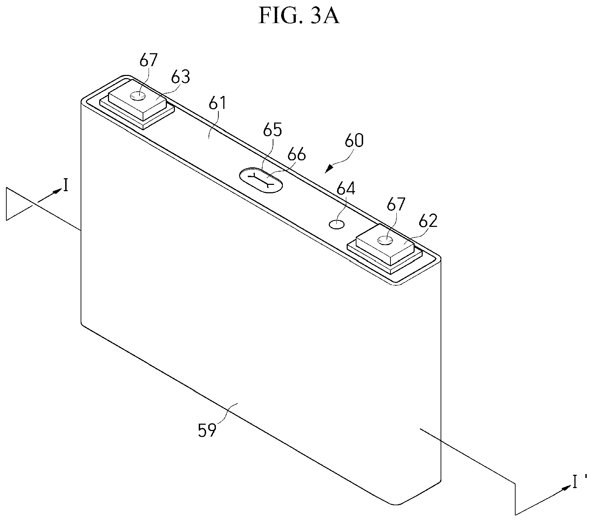

FIG. 3A is a top perspective view of a prismatic secondary battery, according to some embodiments of the present disclosure.

A case 59 may define an overall appearance of the prismatic secondary battery, and may be made of a conductive metal, such as aluminum, aluminum alloy, or nickel-plated steel. In addition, the case 59 may provide a space for accommodating an electrode assembly therein.

A cap assembly 60 may include a cap plate 61 that covers the opening of the case 59. In some examples, the case 59 and the cap plate 61 may be made of a conductive material. Here, a first terminal 63 and a second terminal 62 may be electrically connected to respective positive and negative (or negative and positive) electrodes inside the case, and may be installed to protrude outward through the cap plate 61.

The cap plate 61 may be equipped with an electrolyte injection port 64 formed to install a sealing plug (or seal pin), and a vent 66 formed with a notch 65. The vent 66 may be included for discharging gas generated inside the secondary battery.

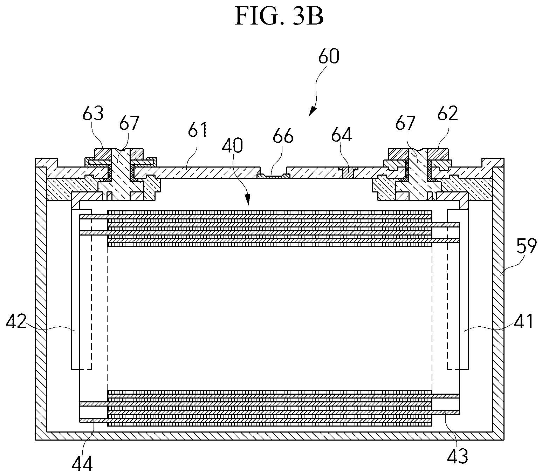

FIG. 3B is a cross-sectional view taken along the line I-I' of FIG. 3A, according to some embodiments of the present disclosure.

As shown in FIG. 3B, a prismatic secondary battery may include an electrode assembly 40, a first current collector 41, a first terminal 62, a second current collector 42, a second terminal 63, a case 59, and a cap assembly 60.

An electrode assembly 40 may be formed by winding or stacking a stack of a first electrode plate, a separator, and a second electrode plate, which are formed as thin plates or films. When the electrode assembly 40 is a wound stack, a winding axis may be parallel to the longitudinal direction (e.g., the y direction) of the case 59. In some other embodiments, the electrode assembly 40 is a stack type rather than a winding type, and the shape of the electrode assembly 40 is not limited in the present disclosure. In addition, the electrode assembly 40 may be a Z-stack electrode assembly in which a positive electrode plate and a negative electrode plate are inserted into both sides of a separator, which is then bent into a Z-stack. In addition, one or more electrode assemblies may be stacked such that long sides of the electrode assemblies are adjacent to each other and accommodated in the case, and the number of electrode assemblies in the case is not limited in the present disclosure.

The first electrode plate of the electrode assembly may act as a negative electrode, and the second electrode plate may act as a positive electrode. Of course, the reverse is also possible.

The first electrode plate may be formed by applying a first electrode active material, such as graphite, carbon, or the like, to a first electrode current collector formed of a metal foil, such as copper, a copper alloy, nickel, a nickel alloy, or the like. The first electrode plate may include a first electrode tab 43 (e.g., a first uncoated portion) that is a region to which the first electrode active material is not applied. The first electrode tab 43 may act as a current flow path between the first electrode plate and the first current collector 41. In some embodiments, when the first electrode plate is manufactured, the first electrode tab 43 is formed by being cut in advance to protrude to one side of the electrode assembly 40, or the first electrode tab 43 protrudes to one side of the electrode assembly 40 more than (e.g., farther than or beyond) the separator without being separately cut.

The second electrode plate may be formed by applying a second electrode active material, such as a transition metal oxide, on a second electrode current collector formed of a metal foil, such as aluminum or an aluminum alloy. The second electrode plate may include a second electrode tab 44 (e.g., a second uncoated portion) that is a region to which the second electrode active material is not applied.

The second electrode tab 44 may act as a current flow path between the second electrode plate and the second current collector 42. In some embodiments, the second electrode tab 44 may be formed by being cut in advance to protrude to the other side (e.g., the opposite side) of the electrode assembly when the second electrode plate is manufactured, or the second electrode plate may protrude to the other side of the electrode assembly more than (e.g., farther than or beyond) the separator without being separately cut.

In FIG. 3B, the first electrode tab 43 and the second electrode tab 44 are shown as being located on a right side surface and a left side surface of the electrode assembly 40, respectively. However, in some other embodiments, the first electrode tab 43 and the second electrode tab 44 may both be located on the right side surface or the left side surface of the electrode assembly 40. In addition, in some other embodiments, the first electrode tab 43 and the second electrode tab 44 may be located on an upper surface of the electrode assembly 40.

Here, the left side surface, the right side surface, and the upper surface of the electrode assembly 40 are based on the secondary battery shown in FIGS. 2 and 3 for simplicity of description. The left side surface is a surface to which the second current collector 42 is bonded among vertical side surfaces of the electrode assembly 40, and the right side surface is a surface which is opposite to the left surface and to which the first current collector 41 is bonded. In addition, the upper surface is a surface which faces the cap assembly 60, on which the first terminal 62 and the second terminal 63 are installed, among horizontal surfaces of the electrode assembly 40. Accordingly, the names of the terms used above, such as the left side surface, the right side surface, and the upper surface of the electrode assembly 40, may be changed when the secondary battery is rotated laterally or vertically.

The separator can prevent or substantially reduce instances of a short circuit between the first electrode and the second electrode while allowing movement of lithium ions therebetween. The separator may be made of, for example, a polyethylene film, a polypropylene film, a polyethylene-polypropylene film, or the like.

In some embodiments, the electrode assembly 40 is accommodated in the case 59 along with an electrolyte.

In the electrode assembly 40, the first current collector 41 and the second current collector 42 may be welded and connected to the first electrode tab 43 extending from the first electrode plate and the second electrode tab 44 extending from the second electrode plate, respectively. As mentioned above, in some embodiments in which the first electrode tab 43 and the second electrode tab 44 are located at the top of the electrode assembly 40, the first and second current collectors are located at the top of the electrode assembly 40.

As illustrated in FIG. 3B, the first current collector 41 and the second current collector 42 are connected to the first terminal 62 and the second terminal 63 through connection members 67, respectively. In some embodiments, the connection members 67 may each have an outer peripheral surface that is threaded, and may be fastened to the first terminal 62 and the second terminal 63 by screwing. However, the present disclosure is not limited thereto. For example, the connection members 67 may also be coupled to the first terminal 62 and the second terminal 63 by riveting or welding.

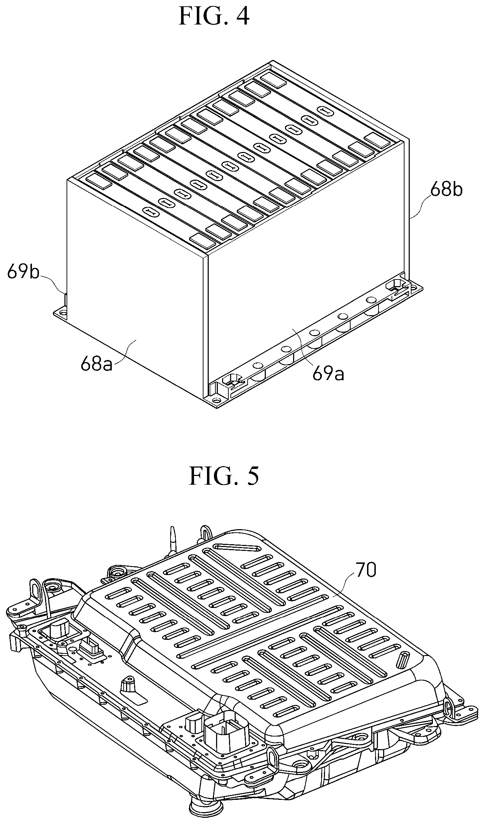

FIG. 4 is an example view of a secondary battery module in which prismatic secondary batteries are arranged according to some embodiments of the present disclosure. With the increase in secondary battery capacity for driving electric vehicles or the like, a secondary battery module may be manufactured by arranging and connecting a plurality of secondary battery cells transversely and/or longitudinally. The plurality of secondary batteries may be arranged in a space defined by a pair of facing end plates 68a and 68b and a pair of facing side plates 69a and 69b. The secondary batteries may be designed appropriately in a suitable arrangement (e.g., direction) and number to obtain desired voltage and current capabilities.

FIG. 5 is a view schematically showing the configuration of a battery pack 70 according to some embodiments of the present disclosure. Referring to FIG. 5, a battery pack 70 may include an assembly to which individual batteries are electrically connected and a pack housing accommodating the same. In the drawings, for simplicity of illustration, components including a bus bar, a cooling unit, external terminals for electrically connecting batteries, etc., are not shown; however, such components may be included.

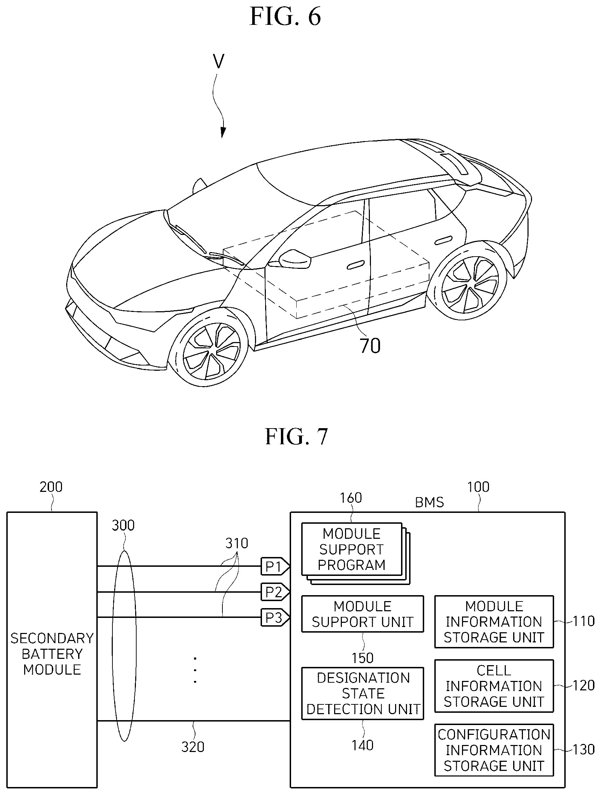

The battery pack 70 may be mounted on (or in) a vehicle. The vehicle may be, for example, an electric vehicle, a hybrid vehicle, or a plug-in hybrid vehicle. The vehicle may be a four-wheeled vehicle or a two-wheeled vehicle, but is not limited thereto. FIG. 6 shows a vehicle V which includes the battery pack 70 shown in FIG. 5 on the lower body thereof. The vehicle V may operate by (e.g., may be powered by) receiving power from the battery pack 70.

A secondary battery pack may include a battery and a battery management system (BMS) for managing the battery. The BMS can measure and grasp a voltage (V), a current (I), and a temperature (T) of the battery mounted on an electric vehicle or an energy storage system (ESS) in advance through sensors and performs control such that the battery exhibits optimal performance.

The battery management system may include a detection device, a balancing device, and a control device. The battery module may include a plurality of cells connected to each other in series and/or parallel. The battery modules may be connected to each other in series and/or in parallel.

The detection device may detect a state of a battery (e.g., voltage, current, temperature, etc.) to output state information indicating the state of the battery. The detection device may detect the voltage of each cell constituting the battery or of each battery module. The detection device may detect current flowing through each battery module constituting the battery module or the battery pack. The detection device may also detect the temperature of a cell and/or module on at least one point of the battery and/or an ambient temperature.

The balancing device may perform a balancing operation of a battery module and/or cells constituting the battery module. The control device may receive state information (e.g., voltage, current, temperature, etc.) of the battery module from the detection device. The control device may monitor and calculate the state of the battery module (e.g., voltage, current, temperature, state of charge (SOC), life span (state of health (SOH)), etc.) on the basis of the state information received from the detection device. In addition, on the basis of the monitored state information, the control device may perform a control function (e.g., temperature control, balancing control, charge/discharge control, etc.) and a protection function (e.g., over-discharge, over-charge, over-current protection, short circuit, fire extinguishing function, etc.). In addition, the control device may perform a wired or wireless communication function with an external device of the battery pack (e.g., a higher level controller or vehicle, charger, power conversion system, etc.).

The control device may control charging/discharging operation and protection operation of the battery. To this end, the control device may include a charge/discharge control unit, a balancing control unit, and/or a protection unit.

The battery management system is a system that can monitor the battery state and perform diagnosis and control, communication, and protection functions, and may calculate the charge/discharge state, calculate battery life or state of health (SOH), cut off, as necessary, battery power (e.g., relay control), control thermal management (e.g., cooling, heating, etc.), perform a high-voltage interlock function, and/or may detect and/or calculate insulation and short circuit conditions.

A relay may be a mechanical contactor that is turned on and off by the magnetic force of a coil or a semiconductor switch, such as a metal oxide semiconductor field effect transistor (MOSFET).

The relay control may have a function of cutting off the power supply from the battery if (or when) a problem occurs in the vehicle and the battery system and may include one or more relays and pre-charge relays at the positive terminal and the negative terminal, respectively.

In the pre-charge control, there is a risk of inrush current occurring in the high-voltage capacitor on the input side of the inverter when the battery load is connected. Thus, to prevent inrush current when starting a vehicle, the pre-charge relay may be operated before connecting the main relay and the pre-charge resistor may be connected.

The high-voltage interlock is a circuit that can use a small signal to detect whether or not all high-voltage parts of the entire vehicle system are connected and may have a function of forcibly opening a relay if (or when) an opening occurs at even one location on the entire loop.

In the past, it has been necessary to download and use different BMSs for each model/pack type and/or cell type, but according to the present disclosure, in cases like the above, one BMS may be used for a plurality of modules/packs or cell types.

Hereinafter, a configuration and a method in which various types of applications and cell types may be supported with one BMS will be described. In this specification, a module/pack is used to mean a module or a pack, and hereinafter, the module/pack is collectively referred to as the term "module."

FIG. 7 is a block diagram of a BMS 100 according to some embodiments of the present disclosure.

The BMS 100 is connected to a secondary battery module 200 through cables 300 including general-purpose input/output (GPIO) ports 310 and communication lines 320. Here, the secondary battery module 200 means a group of cells in which specific types of secondary battery cells are arranged in series and/or parallel as described above and manufactured into a specific shape with specific voltage and current specifications. It is also noted that the secondary battery module 200 herein is used as meaning including the secondary battery pack 70 described above. The GPIO port is a port or pin for digital signals of an integrated circuit or electric circuit and refers to a "multipurpose or general-purpose input/output pin" of which operations including input or output may be controlled at runtime by a user. The GPIO ports may be included in the battery management system.

The BMS 100 may store various module support programs 160 for supporting various secondary battery module types and/or various cell types and thus may detect a type of the connected module 200 and a type of cell used therein and perform battery management tasks using a corresponding support program. Here, examples of module types include standalone modules without a communication function, smart modules with a communication function, and custom modules tailored to specific users. In addition, examples of cell types may include cell shapes and cell standards or specifications of cylindrical, prismatic, and pouch-type cells.

The BMS 100 may store module type information and cell type information as described above, may detect a module type and cell type of the connected module 200, and may constitute or retrieve a corresponding support program to manage a corresponding module and cell.

The module type of the connected module 200 and types of cells included therein may be detected by reading a state of the GPIO port 310. For example, among the GPIO ports 310, some ports may be used as ports for designating configuration information of a module support program of the BMS 100. The ports for designating the configuration information may be set to a high level state (state "1") or a low level state (state "0"), thereby designating two states per port.

BMS 100 may read a state of a configuration information designation port, may recognize a type and cell type of the connected module 200, and may retrieve an appropriate module support program 160 using corresponding configuration information.

As in the outline described above, the BMS 100 may be one BMS storing various module support programs 160 for supporting various types of secondary battery modules and cells and may include the following elements as components for supporting various types of modules and cells.

A module information storage unit 110 may be configured to store information indicating a type of the connected module 200 (for example, a first identifier assigned according to the type of the module 200).

A cell information storage unit 120 may be configured to store information indicating a type of a cell included in the connected module 200 (for example, a second identifier assigned according to a type of a cell).

A configuration information storage unit 130 may be configured to store configuration information for each module type stored in the module information storage unit 110 and configuration information for each cell type stored in the cell information storage unit 120. The configuration information may be information required for constituting, retrieving, or executing the module support programs 160.

A designation state detection unit 140 may be configured to read a level state of a configuration information designation port set in one or more of the GPIO ports 310 and may detect a state designated according to the connected module 200.

A module support unit 150 may be configured to access the configuration information storage unit 130, the module information storage unit 110, and the cell information storage unit 120 to retrieve configuration information for each module type and configuration information for each cell type corresponding to the detected designated state and configured to retrieve and execute the support program 160 suitable (or appropriate) for the corresponding module 200. In some embodiments, the module support unit is configured to detect a state of the configuration information designation port.

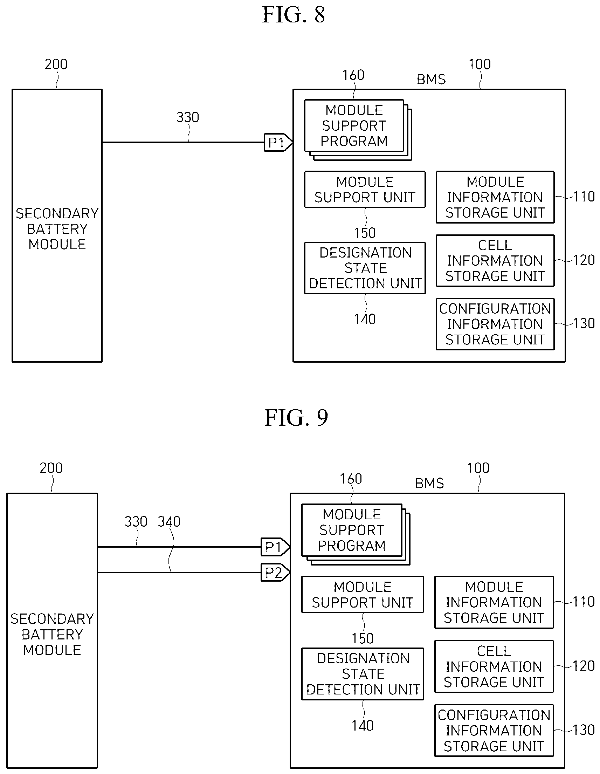

FIG. 8 illustrates a block diagram according to embodiments in which one configuration information designation port 330 among the GPIO ports is used.

Since one configuration information designation port 330 is used, the port may be provided in two level states of 0 or 1. For example, in some embodiments, assuming that, as shown in Table 1 below, configuration information in which a module type is set to a smart module when a state of a port P1 is 1 and is set to a standalone module when the state of the port is 0 is stored in the configuration information storage unit 130, the designation state detection unit 140 of the BMS 100 may check the configuration information designation port 330 to detect whether a state thereof is 1 or 0. The module support unit 150 may retrieve the module support program 160 corresponding to the detected state in cooperation with the configuration information storage unit 130 according to the detected state and may perform a management task on the connected module 200. In this case, in other embodiments, the module information storage unit 110 and the cell information storage unit 120 may be involved in the operation of the module support unit 150.

**TABLE 1**

| Port \ Value | 1 | 0 |
|---|---|---|
| P1 | Smart module | Standalone module |

FIG. 9 illustrates a diagram according to other embodiments in which two configuration information designation ports 330 and 340 among the GPIO ports are used.

Since each port of the two configuration information designation ports 330 and 340 may be designated in two level states of 0 or 1, the present embodiment may provide cases of 2²=4.

For example, when, as shown in Table 2 below, configuration information is stored in which a module type is set to a smart module when a state of a port P1 is 1 and is set to a standalone module when the state of the port P1 is 0, and a cell type is set to a first cell type (for example, a cylindrical cell) when a state of a port P2 is 1 and is set to a second cell type (for example, a prismatic cell) when the state of the port P2 is 0, the BMS 100 may support two module types and two cell types. To this end, the designation state detection unit 140 of the BMS 100 may check the configuration information designation ports 330 and 340 to detect whether each level state is 1 or 0. The module support unit 150 may retrieve the module support program 160 corresponding to the detected state in cooperation with the configuration information storage unit 130 according to the detected state and may perform a management task on the connected module 200. In this case, in other embodiments, the module information storage unit 110 and the cell information storage unit 120 may be involved in the operation of the module support unit 150.

**TABLE 2**

| Port \ Value | 1 | 0 |
|---|---|---|
| P1 | Smart module | Standalone module |
| P2 | Cylindrical cell | Prismatic cell |

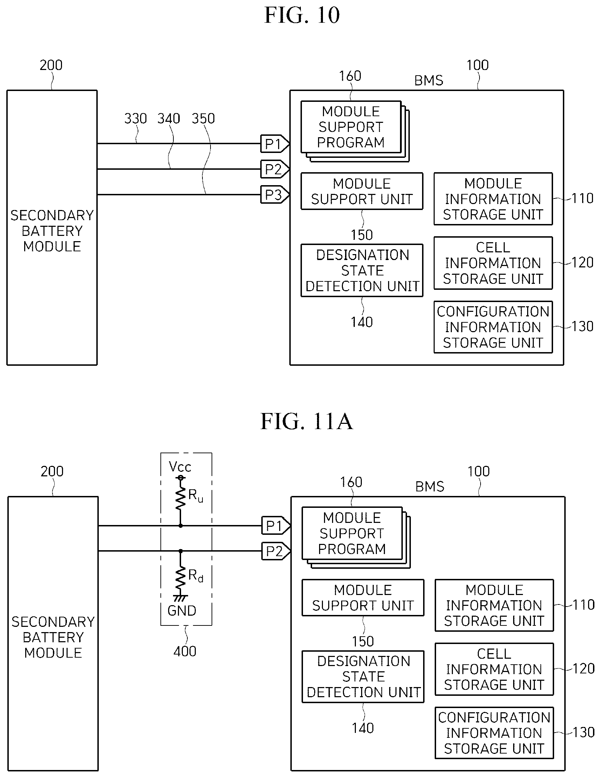

FIG. 10 illustrates embodiments in which three configuration information designation ports 330, 340, and 350 among the GPIO ports are used.

Since each port of the three configuration information designation ports 330, 340, and 350 may be designated in two level states of 0 or 1, the present embodiment may provide cases of 2³=8.

For example, assuming that, as shown in Table 3 below, a configuration information is stored in which a module type is set to a smart module when a state of a port P1 is 1 and is set to a standalone module when the state of the port P1 is 0, a cell type is set to a first cell type (for example, a cylindrical cell) when a state of a port P2 is 1 and is set to a second cell type (for example, a prismatic cell) when the state of the port 2 is 0, and a cell type is set to a third cell type (for example, a cell delivered to H Company) when a state of a port P3 is 1 and is set to a fourth cell type (for example, a cell delivered to T Company) when the state of the port P3 is 0, the BMS 100 may support two module types and four cell types. To this end, the designation state detection unit 140 of the BMS 100 may check the configuration information designation ports 330, 340, and 350 to detect whether each level state is 1 or 0. The module support unit 150 may retrieve the module support program 160 corresponding to the detected state in cooperation with the configuration information storage unit 130 according to the detected state and may perform a management task on the connected module 200. In this case, in other embodiments, the module information storage unit 110 and the cell information storage unit 120 may be involved in the operation of the module support unit 150.

**TABLE 3**

| Port \ Value | 1 | 0 |
|---|---|---|
| P1 | Smart module | Standalone module |
| P2 | Cylindrical cell | Prismatic cell |
| P3 | Cell delivered to H Company | Cell delivered to T Company |

FIG. 11A illustrates a diagram according to a method of setting a state of a configuration information designation port according to some embodiments.

FIG. 11A illustrates that a pull-up resistor Rᵤ is connected between a port P1 and a terminal Vcc, and a pull-down resistor R_{d} is connected between a port P2 and a ground GND. In this case, the port P1 is in a state of level 1, and the port P2 is in a state of level 0. Conversely, when the pull-up resistor Rᵤ is connected between the port P2 and the terminal Vcc, and the pull-down resistor R_{d} is connected between the port P1 and the ground GND, the port P1 will be in a state of level 0, and the port P2 will be in a state of level 1. In this way, four port states may be set using four combinations of the pull-up resistor Rᵤ and the pull-down resistor R_{d}.

The depicted embodiment shown in FIG. 11A shows a configuration in which the pull-up resistor Rᵤ and the pull-down resistor R_{d} are mounted on a separate circuit board 400 and inserted into a GPIO line connecting the secondary battery module 200 and the BMS 100. However, in other embodiments, a pull-up resistor and a pull-down resistor may be included inside a secondary battery module. In this case, when a module is manufactured, the pull-up resistor and the pull-down resistor are combined and used in a level state to designate a module type and a cell type. In addition, in other embodiments, a pull-up resistor and a pull-down resistor may be included in a BMS. In this case, the pull-up resistor and the pull-down resistor may be combined and used in the BMS to match a type and cell type of a secondary battery module manufactured for general use.

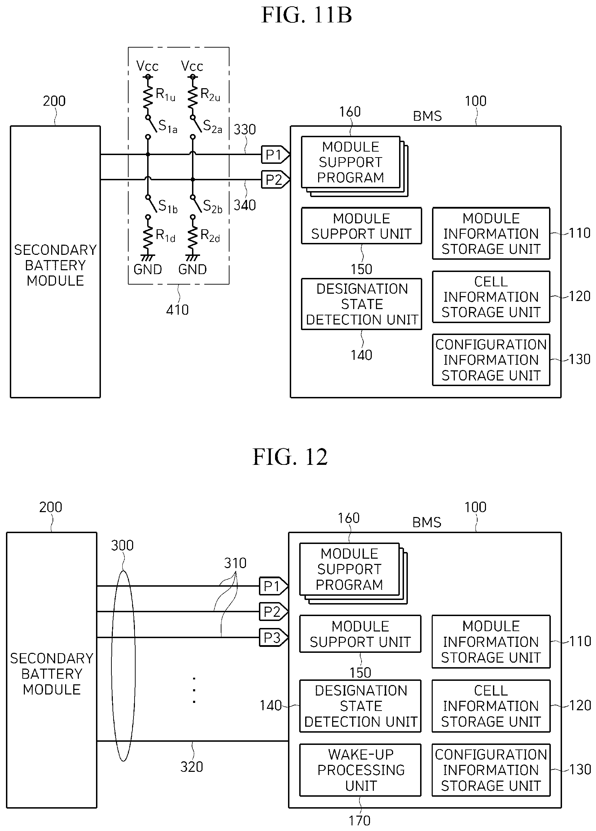

FIG. 11B illustrates a diagram according to a method of setting a state of a configuration information designation port according to other embodiments.

A pull-up resistor R₁ᵤ is connected to a port P1 through a switch S₁ₐ, and a pull-down resistor R_{1d} is connected thereto through a switch S_{1b}. A pull-up resistor R₂ᵤ is connected to a port P2 through a switch S₂ₐ, and a pull-down resistor R_{2d} is connected thereto through a switch S_{2b}. By combining the four switches S₁ₐ, S_{1b}, S₂ₐ, and S_{2b}, four states 00, 01, 10, and 11 may be set.

In some embodiments, the configuration information designation port may include a pair of pull-up and pull-down resistors connected to each port. In some embodiments, two switches are included in which a first switch may be configured to switch on or off the pull-up resistor, and a second switch may be configured to switch on or off the pull-down resistor.

Even in the depicted embodiment of FIG. 11B, the pull-up resistors, the pull-down resistors, and the switches may be mounted on a separate circuit board 410 and inserted into a GPIO line connecting the secondary battery module 200 and the BMS 100, may be included inside the secondary battery module, or may be included in the BMS.

FIG. 12 illustrates a configuration of a BMS 100 according to other embodiments of the present disclosure.

In this depicted embodiment, the descriptions of a module information storage unit 110, cell information storage unit 120, configuration information storage unit 130, and module support unit 150 is the same as those provided with reference to FIG. 7, and a wake-up processing unit 170 may be additionally included. When a secondary battery module/pack is not charged or discharged for a specific period of time, the wake-up processing unit 170 may minimize power usage by allowing the BMS to enter a low-power mode (sleep mode) or a power-off mode (shutdown mode) and may wake up the BMS 100 in the low-power mode or the power-off mode to restart the operation thereof.

In this depicted embodiment, a time point at which a designation state detection unit 140 detects a level state of a configuration information designated port set in one or more of GPIO ports 310 may be a time point at which the wake-up processing unit 170 wakes up the BMS 100 in the low-power mode or power-off mode to restart the operation thereof.

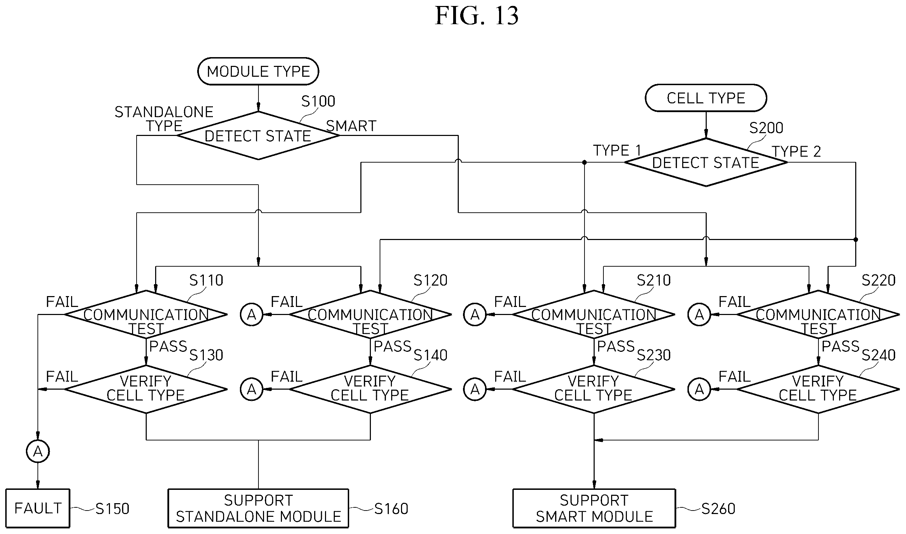

FIG. 13 illustrates a process in which a designation state detection unit 140 of a BMS 100 according to some embodiments detects a configuration information designation state and determines integrity by reading a configuration information designation port 330, 340, or 350. The depicted process is a process of processing two module types (standalone module and smart module) and two cell types (cylindrical cell and prismatic cell) using two ports as shown in the depicted embodiment in FIG. 9 and Table 2.

The designation state detection unit 140 of the BMS 100 may detect the configuration information designation state from the configuration information designation port 330, 340, or 350, determine a module type and a cell type designated in a connected module 200, determine whether the module type is a standalone type or a smart type (act S 100), and determine whether the cell type is a first cell type or a second cell type (act S200).

When a type of a secondary battery module 200 is determined to be a standalone type, a communication test can be performed to determine whether communication is performed with an apparatus (vehicle, golf cart, or other electrical appliance) in which the secondary battery module 200 is installed (acts S110 and S120). The communication test is also performed when the type of the secondary battery module 200 is determined to be a smart type (acts S210 and S220). The communication test may be performed, for example, for confirming that a vehicle control unit (VCU) of the vehicle equipped with the secondary battery module 200 transmits a communication signal and the BMS performs a response according to the communication signal. In the communication test (acts S110 and S120) in the case of a standalone module, when communication is not performed, the communication test is passed, and when communication is performed, the communication test is failed. In the communication test (acts S210 and S220) in the case of a smart module, when communication is performed, the communication test is passed, and when communication is not performed, the communication test is failed.

When a communication test result is a fail, since there is an error in a state detected in the configuration information designation port 330, 340, or 350, there is an error in designating configuration information of the secondary battery module 200, or there are other errors, a management operation of the BMS 100 is not performed, and FAULT processing such as re-designating configuration information or performing error detection can be performed (act S150).

When both the communication test for the standalone module (acts S110 and S120) and the communication test for the smart module (acts S210 and S220) are determined to be a pass, a cell type that is previously detected is verified. The cell type may be verified, for example, by comparing cell information stored in a cell information storage unit 120 of the BMS 100 with a state designated in the configuration information designation port 330, 340, or 350 among a GPIO port.

First, in the case of a standalone module, when the previously detected cell type is the first cell type, after the first communication test (act S110) for the standalone module, the first cell type is verified (act S130), and when the previously detected cell type is the second cell type, after the second communication test (act S120) for the standalone module, the second cell type is verified (act S140). When the verification of the first cell type (act S130) or the verification of the second cell type (act S140) is determined to be a pass, since it is verified that the secondary battery module 200 installed in a product is a standalone module and a cell type is the first cell type or the second cell type, the BMS 100 (for example, a module support unit 150) retrieves a support program 160 for a corresponding module and executes an operation for supporting a corresponding standalone module (act S160).

Next, in the case of a smart module, when a cell type that is previously detected is the first cell type, after a first communication test (act S210) for the smart module, the first cell type is verified (act S230), and when the previously detected cell type is the second cell type, after a second communication test (act S220) for the smart module, the second cell type is verified (act S240). When the verification of the first cell type (act S230) is determined to be a pass or the verification of the second cell type (act S240) is determined to be a pass, since it is verified that the secondary battery module 200 installed in a product is a smart module and a cell type is the first cell type or the second cell type, the BMS 100 (for example, the module support unit 150) retrieves a support program 160 for a corresponding module and executes an operation for supporting a corresponding smart module (act S260).

Table 4 below shows an example of a configuration information designation state for managing an RXV product, which is one of the low emission vehicle (LEV) models used as golf carts, and an after-market product with one BMS. The one BMS provided to customers may support both the RXV product and the after-market product, and a product may be designated by the customer. That is, for the RXV product, a port P1 may be designated to state 1, and for the after-market product, the port P1 may be designated to state 0. A port P2 may be designated to state 1 when a cell of S Company is used in the RXV product or after-market product and may be designated to state 0 when a cell of L Company is used therein. A state may be designated using a circuit board 410 shown in FIG. 11B, but the present disclosure is not limited thereto.

**TABLE 4**

| Port \ Value | 1 | 0 |
|---|---|---|
| P1 | RXV | After market |
| P2 | Cell of S Company | Cell of L Company |

A BMS according to the embodiments described above can be used as a component of a secondary battery pack as shown in FIG. 5. For example, the secondary battery pack may include a secondary battery module in which secondary battery cells are arranged as shown in FIG. 4, and the BMS according to the embodiments. Here, the BMS may be configured to detect a configuration information designation state from a configuration information designation port to determine a module type and cell type designated in the secondary battery module, perform a communication test with the secondary battery module, and verify a type of a cell included in the secondary battery module.

To this end, the BMS may also include a GPIO port that may be connected to the cell of the secondary battery module through a cable, a module support program that is for supporting the secondary battery module, a configuration information designation port that designates configuration information of the module support program and is included in the GPIO port, and a module support unit that detects a state of the configuration information designation port to recognize and/or identify a type and cell type of the secondary battery module, and retrieves the module support program corresponding to the type and cell type to manage the secondary battery module.

More specifically, the BMS may include a module information storage unit configured to store information indicating a type of a secondary battery module, a cell information storage unit configured to store information indicating a type of a cell included in the secondary battery module, a configuration information storage unit configured to store configuration information for each type of the secondary battery module stored in the module information storage unit and configuration information for each cell type stored in the cell information storage unit, and a designation state detection unit configured to read a state of the configuration information designation port and detect a state designated according to the secondary battery module.

In the past, it has been necessary to download and use different BMSs for each model/pack type and/or cell type, but according to the present disclosure, one BMS may be used in common for a plurality of modules/packs or cell types.

In some embodiments, the storage units described herein may include general purpose storage devices. In some embodiments, the units described herein may include software components.

In some embodiments, a method of operating a BMS may be provided which may include general-purpose input/output (GPIO) ports connected to a secondary battery module and a configuration information designation port included in the GPIO ports configured to designate configuration information of a module support program of a plurality of module support programs configured to support a plurality of secondary battery module types and various cell types. The method may include: detecting, via a module support unit, a state of the configuration information designation port to identify a type of the secondary battery module and a cell type; and retrieving, via the module support unit, the module support program, wherein the module support program corresponds to the type and the cell type to manage the secondary battery module.

Although the present disclosure has been described above with respect to some embodiments thereof, the present disclosure is not limited thereto. Various suitable modifications and variations can be made thereto by those skilled in the art within the scope of the present disclosure.

## Claims

1. A battery management system comprising:
general-purpose input/output (GPIO) ports connected to a secondary battery module;
a plurality of module support programs configured to support a plurality of secondary battery module types and various cell types;
a configuration information designation port configured to designate configuration information of a module support program of the plurality of module support programs and included in the GPIO ports; and
a module support unit configured to detect a state of the configuration information designation port to identify a type of the secondary battery module and a cell type and configured to retrieve the module support program corresponding to the type and the cell type to manage the secondary battery module.

2. The battery management system of claim 1, further comprising:
a module information storage unit configured to store information indicating the type of the secondary battery module;
a cell information storage unit configured to store information indicating the cell type of a cell included in the secondary battery module;
a configuration information storage unit configured to store configuration information for each secondary battery module type stored in the module information storage unit and configuration information for each cell type stored in the cell information storage unit; and
a designation state detection unit configured to read the state of the configuration information designation port and detect a state designated according to the secondary battery module.

3. The battery management system of claim 1 or claim 2, wherein the module support unit is configured to retrieve configuration information for each type of the secondary battery module and configuration information for each cell type, which correspond to the detected state that is designated, and configured to retrieve and execute the module support program for the secondary battery module.

4. The battery management system of any preceding claim, wherein the configuration information designation port is at least one port among the GPIO ports.

5. The battery management system of any preceding claim, wherein the configuration information designation port includes a pair of pull-up and pull-down resistors connected to each port among the GPIO ports.

6. The battery management system of any of claims 1 to 4, wherein the configuration information designation port includes:
a pair of pull-up and pull-down resistors connected to each port among the GPIO ports;
a first switch configured to switch on or off the pull-up resistor; and
a second switch configured to switch on or off the pull-down resistor.

7. The battery management system of any preceding claim, further comprising a wake-up processing unit, wherein the module support unit is further configured to detect a designation state at a time point,
at which the wake-up processing unit is configured to wake up the battery management system and restart an operation of the battery management system.

8. The battery management system of any of claims 2 to 7, wherein the designation state detection unit is configured to:
detect a configuration information designation state from the configuration information designation port to determine a module type and cell type designated in the secondary battery module from the detected state designated according to the secondary battery module,
perform a communication test with the secondary battery module, and
verify the cell type of the cell included in the secondary battery module.

9. A secondary battery pack comprising:
a secondary battery module; and
a battery management system including:
general-purpose input/output (GPIO) ports,
a module support program configured to support the secondary battery module,
a configuration information designation port configured to designate configuration information of the module support program and included in the GPIO ports, and
a module support unit configured to detect a state of the configuration information designation port to recognize a type of the secondary battery module and a cell type and to retrieve the module support program corresponding to the type and the cell type to manage the secondary battery module.

10. The secondary battery pack of claim 9, wherein the battery management system further includes:
a module information storage unit configured to store information indicating the type of the secondary battery module;
a cell information storage unit configured to store information indicating a type of a cell included in the secondary battery module;
a configuration information storage unit configured to store configuration information for each secondary battery module type stored in the module information storage unit and configuration information for each cell type stored in the cell information storage unit; and
a designation state detection unit configured to read the state of the configuration information designation port and to detect a state designated according to the secondary battery module.

11. The secondary battery pack of claim 9 or claim 10, wherein the configuration information designation port is at least one port among the GPIO ports.

12. The secondary battery pack of any of claims 9 to 11, wherein the configuration information designation port includes a pair of pull-up and pull-down resistors connected to each port among the GPIO ports.

13. The battery management system of any of claims 9 to 11, wherein the configuration information designation port includes:
a pair of pull-up and pull-down resistors connected to each port among the GPIO ports;
a first switch configured to switch on or off the pull-up resistor; and
a second switch configured to switch on or off the pull-down resistor.

14. The secondary battery pack of any of claims 9 to 13, wherein the designation state detection unit is configured to:
detect a configuration information designation state from the configuration information designation port to determine a module type and cell type designated in the secondary battery module,
perform a communication test with the secondary battery module, and
verify a type of a cell included in the secondary battery module.

15. A method of operating a battery management system comprising general-purpose input/output (GPIO) ports connected to a secondary battery module and a configuration information designation port included in the GPIO ports configured to designate configuration information of a module support program of a plurality of module support programs configured to support a plurality of secondary battery module types and various cell types, the method comprising:
detecting, via a module support unit, a state of the configuration information designation port to identify a type of the secondary battery module and a cell type; and
retrieving, via the module support unit, the module support program, wherein the module support program corresponds to the type and the cell type to manage the secondary battery module.
